# EUROPÄISCHE PATENTSCHRIFT

(11) **EP 3 362 854 B1**
(45) Veröffentlichungstag und Bekanntmachung des Hinweises auf die Patenterteilung: **04.05.2022**
(21) Anmeldenummer: 16782025.7
(22) Anmeldetag: 07.10.2016
(51) Int. Cl.: G03F 1/50, G03F 7/40, G03F 7/00

(54) **VERFAHREN ZUR HERSTELLUNG EINER MIKROSTRUKTUR IN EINER FOTOLITHOGRAPHIETECHNIK**
METHOD FOR PRODUCING A MICROSTRUCTURE IN A PHOTOLITHOGRAPHY TECHNIQUE
PROCÉDÉ DE PRODUCTION D'UNE MICROSTRUCTURE DANS LE DOMAINE TECHNIQUE DE LA PHOTOLITHOGRAPHIE

(30) Priorität: 15.10.2015 DE 102015117556
(43) Veröffentlichungstag der Anmeldung: 22.08.2018
(73) Patentinhaber: Universität Kassel, 34125 Kassel (DE)
(72) Erfinder: KHUDHAIR, Basim, 34125 Kassel (DE); VIERECK, Volker, 34131 Kassel (DE); HILLMER, Volker, 34132 Kassel (DE)
(74) Vertreter: Kleine, Hubertus
(86) Internationale Anmeldenummer: PCT/EP2016/074047
(87) Internationale Veröffentlichungsnummer: WO 2017/063951

(56) Entgegenhaltungen:
- WO-A2-2004/073379
- CN-A- 104 849 966
- JP-A- S6 049 338
- JP-A- S6 161 162
- JP-A- 2005 148 514
- US-A- 3 507 592
- US-A1- 2002 018 964
- US-A1- 2013 164 656

## Beschreibung

Die Erfindung betrifft ein Verfahren zur Herstellung einer Mikrostruktur in einer Fotolithographietechnik.

Fotolithographie ist eine Standardmethode zur Strukturierung von Halbleiterbauelementen bzw. integrierten Schaltungen und auch mikromechanischen Bauteilen, die nachfolgend unter der Bezeichnung "Mikrostrukturen" zusammengefasst werden. In der Fotolithographie wird ein Strukturmuster mittels einer Fotomaske durch gleichmäßige Beleuchtung mit parallelem Licht auf eine fotosensitive Schicht ("Fotolack") übertragen. Die beleuchtete Schicht wird nachfolgend entwickelt, z.B. in einem Ätzschritt, wodurch je nach Art des Fotolacks entweder beleuchtete Bereiche oder unbeleuchtete Bereiche entfernt werden.

Fotomasken für fotolithographische Techniken können als ein- oder doppelseitige Fotomasken ausgebildet sein. Bei doppelseitigen Fotomasken sind Muster aus lichtdurchlässigen und lichtundurchlässigen Bereichen auf beiden gegenüberliegenden Planseiten der Fotomaske angeordnet. Doppelseitige Fotomasken sind beispielsweise aus den Druckschriften US 6,022,645 A oder JP 2013 238692 A bekannt. Die Masken sind so ausgebildet, dass sich die lichtblockenden Bereiche auf der Ober und auf der Unterseite ergänzen, wodurch zur Herstellung der Fotomaske selbst die einzelnen Seiten nur mit einer geringeren räumlichen Auflösung strukturiert werden müssen.

Die Druckschrift WO 2004/073379 A2 beschreibt eine doppelseitig strukturierte Fotomaske, bei deren Belichtung im durchgehenden Licht lateral ein Intensitätsgradient entsteht. Übertragen auf Fotolack führt dieses Intensitätsprofil zu einer lateral variierenden Schichtdicke des entwickelten Fotolacks. Die Druckschrift JP S61 61162 A beschreibt ein lithographisches Verfahren, bei dem zwei Maskenfilme eingesetzt werden, die durch einen transparenten Plastikfilm voneinander getrennt übereinander angeordnet sind. Auch dadurch kann ein lateral in seiner Stärke variierendes Fotolackprofil ausgebildet werden.

Beispielhaft für mikromechanische Strukturen sind Biegebalken (Cantilever), Mikrospiegel oder optische Filterstrukturen zu nennen. Häufig sind diese Strukturen parallel und beabstandet zu einem Trägersubstrat ein- oder zweidimensional ausgebildet, wobei die Struktur nur an mindestens einer Seite mit dem Substrat verbunden sind und ansonsten freistehend sind. Eine derartige Struktur kann aktiv oder passiv gegenüber dem Substrat zu Biegeschwingungen angeregt werden.

Ein Verfahren zur Herstellung einer freistehenden mikromechanischen Struktur ist beispielsweise aus der Druckschrift DE 103 58 967 B4 bekannt. Bei diesem Verfahren wird in einem ersten fotolithographischen Strukturierungsschritt eine in ihrer lateralen Ausdehnung beschränkte planare Elektrode auf ein Substrat aufgebracht. Diese Elektrode dient nachfolgend als eine Art Sockel für die freistehende Struktur. Angrenzend an diesen Sockel wird eine sogenannte Opferschicht auf das Substrat aufgebracht, bevorzugt in gleicher Höhe wie der Sockel. Auf die Opferschicht wird anschließend eine Funktionsschicht, die in einem nächsten Fotolithographieschritt strukturiert wird. Bei dieser Strukturierung wird beispielsweise eine Zunge oder ein Arm gebildet, der auf dem Sockel aufliegt und zumindest zu einer Seite über den Sockel hinaus auf die Opferschicht ragt. Wird sodann, beispielsweise in einem Ätzprozess, die Opferschicht entfernt, verbleibt eine freistehende Struktur, die nur über den Sockel mit dem Substrat verbunden ist.

Das beschriebene Verfahren ist etabliert, es sind jedoch zu seiner Durchführung viele nacheinander erfolgende lithographische Strukturierungsschritte notwendig. Diese erfordern die aufwendige Gestaltung mehrerer lithographischer Fotomasken sowie eine genaue Positionierung dieser Masken während des Herstellungsverfahrens.

Es ist eine Aufgabe der vorliegenden Erfindung, ein Verfahren der eingangs genannten Art zur Herstellung einer Mikrostruktur zu schaffen, das mit einer geringeren Anzahl von Herstellungsschritten und insbesondere mit einer geringeren Anzahl an Fotolithographieschritten auskommt.

Diese Aufgabe wird durch ein Verfahren mit den Merkmalen des unabhängigen Anspruchs gelöst. Vorteilhafte Ausgestaltungen und Weiterbildungen sind Gegenstand der abhängigen Ansprüche.

Ein erfindungsgemäßes Verfahren weist die folgenden Schritte auf: Es wird eine fotosensitive Schicht auf einem Trägersubstrat bereitgestellt und eine Fotomaske mit einem transparenten Substrat auf oder über dem Trägersubstrat der Mikrostruktur angeordnet, wobei die Fotomaske beidseitig mit einem Belichtungsmuster versehen ist, indem an einer dem Trägersubstrat zuweisenden Unterseite des transparenten Substrats mindestens ein unterer lichtundurchlässiger Bereich und an einer gegenüberliegenden Oberseite des transparenten Substrats mindestens ein oberer lichtundurchlässiger Bereich angeordnet ist. Die fotosensitive Schicht wird durch die Fotomaske belichtet, wobei mindestens ein Abschnitt der fotosensitiven Schicht durch Lichtstrahlen belichtet wird, die an einer Kante des oberen lichtundurchlässigen Bereichs gebeugt sind. Durch Entwickeln der fotosensitiven Schicht bildet sich aus dem mindestens einen Abschnitt der fotosensitiven Schicht ein in seiner Dicke lateral variierender Bereich aus. Anschließend wird eine funktionale Schicht auf das Trägersubstrat und die nach dem Entwickeln verbliebene fotosensitive Schicht aufgewachsen, wobei der Bereich variierender Dicke der verbliebenen fotosensitiven Schicht überwachsen wird. Abschließend wird die verbliebene fotosensitive Schicht entfernt.

Durch die Ausnutzung von Beugungserscheinungen an den oberen lichtundurchlässigen Bereichen erfolgt abschnittsweise eine lateral variierende Belichtung der fotosensitiven Schicht, die beim Entwickeln in einer lateral variierenden Dicke der verbleibenden fotosensitiven Schicht resultiert. Die so strukturierte fotosensitive Schicht kann die Grundlage verschiedenster, nachfolgend herstellbarer mikromechanischer Funktionselemente darstellen. Der lateral variierende Verlauf der Lichtintensität wird dabei von der Wahl der Geometrie der Anordnung der lichtundurchlässigen Bereiche und der verwendeten Wellenlänge bzw. Wellenlängenbereiche des Lichts bestimmt. Der Dickenverlauf kann entsprechend durch die gewählte Geometrie maßgeschneidert werden. Beispielsweise kann der in seiner Dicke lateral variierende Bereich als eine flach ansteigende Flanke ausgebildet sein. Die durch die variierende Dicke der verbliebenen fotosensitiven Schicht gebildete Form wird auf die funktionale Schicht übertragen und so eine 3-dimensionale Strukturierung der funktionalen Schicht ermöglicht.

Im Rahmen der Anmeldung ist dabei unter dem Begriff "Licht" elektromagnetische Strahlung im sichtbaren Bereich (vis - visible), im ultravioletten Bereich (uv - ultraviolet), im extremen ultravioletten Bereich (x-uv - extreme ultraviolet) und im Röntgenbereich (x-ray) zu verstehen.

In einer vorteilhaften Ausgestaltung des Verfahrens liegt der obere lichtundurchlässige Bereich einem der unteren lichtundurchlässigen Bereiche gegenüber und überragt diesen zumindest mit einer Kante seitlich. Bevorzugt überragt der obere lichtundurchlässige Bereich den unteren lichtundurchlässigen Bereich dabei seitlich an zumindest einer Kante um einen Abstand, der 2 bis 20 Wellenlängen des Lichts der Lichtstrahlen entspricht. Auf diese Weise können die Beugungserscheinungen besonders effektiv zur Ausbildung der lateral in ihrer Dicke variierenden verbleibenden fotosensitiven Schicht eingesetzt werden,

In einer weiteren vorteilhaften Ausgestaltung des Verfahrens wird eine Kante eines der unteren lichtundurchlässigen Bereiche durch nicht gebeugte parallele Lichtstrahlen unmittelbar auf die fotosensitive Schicht abgebildet, wodurch beim Entwickeln der fotosensitiven Schicht eine nahezu sprunghaft ansteigende Flanke ausbildet wird. Somit können zwei unterschiedlichen Flankentypen, eine flach ansteigende Flanke (gebildet im Bereich lateral variierender Dicke) und eine nahezu sprunghaft ansteigende Flanke in einem Entwicklungsschritt eng benachbart ausgebildet werden. Viele mikromechanische Strukturen, beispielsweise die eingangs genannten frei schwingenden Strukturen, lassen sich bereits auf der Basis zweier derartig unterschiedlicher Flankentypen herstellen.

Dabei weist die funktionale Schicht an der Stelle der flach ansteigenden Flanke eine durchgehende Kante auf, wobei sie ausgehend von der durchgehende Kante zu einer Seite hin mit dem Trägersubstrat verbunden ist und zu der anderen Seite hin zunehmend beabstandet von dem Trägersubstrat verläuft. Weiter weist die funktionale Schicht an der Stelle der steil ansteigenden Flanke eine unterbrochene Kante auf, wobei ein Abschnitt zwischen der durchgehenden Kante und der unterbrochenen Kante freistehend ist.

Mit den genannten Verfahren kann beispielsweise ein Biegebalken oder ein Mikrospiegel hergestellt werden, gebildet durch die funktionale Schicht zwischen der durchgehenden Kante und der unterbrochenen Kante.

In weiteren vorteilhaften Ausgestaltungen des Verfahrens sind an der Unterseite und/oder der Oberseite des transparenten Substrats bereichsweise phasenverschiebend wirkende Schichten und/oder reflexionsvermindernden Schichten angeordnet. Die reflexionsvermindernden Schichten wirken einer inneren Reflexion von Lichtstrahlen, insbesondere von gebeugten Lichtstrahlen, innerhalb des transparenten Substrats entgegen, die das gewünschte Beugungsmuster beeinflussen könnte. Phasenverschiebende Schichten können zur Erhöhung der erzielbaren Auflösung eingesetzt werden.

Die Erfindung wird nachfolgend anhand von Ausführungsbeispielen mithilfe von Figuren näher erläutert. Die Figuren zeigen:
- Figur 1: ein Verfahren zum Herstellen einer Mikrostruktur in einem ersten Ausführungsbeispiel, dargestellt in vier Teilbildern a) bis d);
- Figur 2, 3: jeweils ein Ausführungsbeispiel einer Fotomaske zur Verwendung in einem anmeldungsgemäßen Strukturierungsverfahren in einer Schnittdarstellung;
- Figur 4: eine schematische Darstellung zur näheren Erläuterung eines anmeldungsgemäßen Strukturierungsverfahrens; und
- Figur 5: eine schematische Darstellung eines weiteren Ausführungsbeispiels eines anmeldungsgemäßen Verfahrens zum Herstellen einer Mikrostruktur.

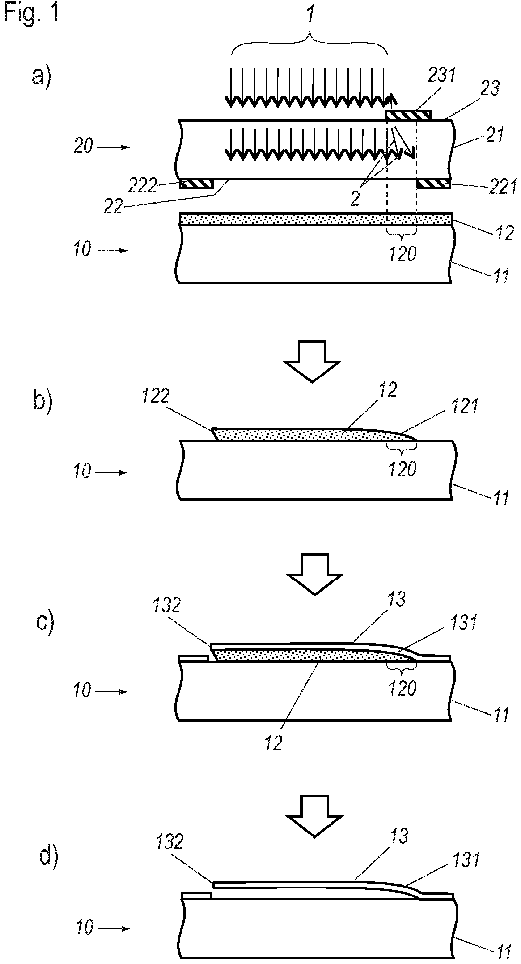

In Figur 1 ist ein erstes Ausführungsbeispiel eines anmeldungsgemäßen Strukturierungsverfahrens zur Herstellung einer Mikrostruktur 10 mithilfe einer Fotomaske 20 in einem Fotolitographieverfahren dargestellt. Figur 1 zeigt in vier Teilbildern a) bis d) verschiedene Stadien des Herstellungsverfahrens anhand von Schnittbildern. Es versteht sich, dass den dargestellten Stadien vorbereitende Herstellungsschritte vorgelagert bzw. nachbereitende Herstellungsschritte sich anschließen können, um die Mikrostruktur 10 herzustellen.

Zur Herstellung der Mikrostruktur 10 wird auf ein Trägersubstrat 11 zunächst eine fotosensitive Schicht 12 aufgebracht. Die Dicke der fotosensitiven Schicht 12 liegt bevorzugt bei bis zu einigen 100 Nanometern (nm). Die fotosensitive Schicht 12 wird danach in dem in Teilbild a) dargestellten Schritt durch die Fotomaske 20 belichtet.

Die Fotomaske 20 ist zu diesem Zweck auf die Mikrostruktur 10 aufgelegt (Kontaktbelichtung) bzw. in geringem Abstand über ihr angeordnet (Proximitybelichtung). Die Fotomaske 20 weist ein transparentes Substrat 21 mit einer zur Mikrostruktur 10 weisenden Unterseite 22 und einer von ihr wegweisenden Oberseite 23 auf.

Bei dem anmeldungsgemäßen Strukturierungsverfahren sind beide Seiten, die Unterseite 22 und die Oberseite 23, der Fotomaske 20 mit einem Lithographiemuster bedeckt. Auf der Unterseite 22 der Fotomaske 20 ist in dem dargestellten Ausschnitt der Fotomaske 20 untere lichtundurchlässige Bereiche 221, 222 angeordnet. Die unteren lichtundurchlässigen Bereiche 221, 222 sind beispielsweise in bekannter Art und Weise aufgebrachte lichtundurchlässige Metallstrukturen, in einer Dicke von etwa 100 nm.

Auf der Oberseite des transparenten Substrats 21 ist auf der rechten Seite ein oberer lichtundurchlässiger Bereich 231 aufgebracht. Der obere lichtundurchlässige Bereich 231 ist beispielsweise ebenfalls eine aufgebrachte Metallschicht. Die lichtundurchlässigen Bereiche 221, 222 und 231 sind streifenförmig, verlaufen also senkrecht zur dargestellten Schnittebene der Figur 1 in gleicher Breite weiter.

Der obere lichtundurchlässige Bereich 231 auf der Oberseite 23 ist dabei so positioniert, dass er mit dem rechten unteren lichtundurchlässigen Bereich 221 auf der Unterseite 22 der Fotomaske 20 in der Schnittrichtung teilweise überlappt. Im Bereich des links angeordneten unteren lichtundurchlässigen Bereichs 222 ist auf der Oberseite 23 kein mit dieser überlappender lichtundurchlässiger Bereich vorgesehen.

Zur Belichtung wird die Anordnung aus Fotomaske 20 und Mikrostruktur 10 mit einem parallelen Lichtstrahlenbündel 1 belichtet. Dabei decken die lichtundurchlässigen Bereiche 221 und 222 auf der Unterseite 22 der Fotomaske 20 die fotosensitive Schicht 12 so ab, dass die entsprechenden Bereiche im Wesentlichen keine Belichtung erfahren. Durch den geringen Abstand zwischen der Unterseite 22 der Fotomaske 20 und der Oberseite der fotosensitiven Schicht 12 wird das Schattenmuster der unteren lichtundurchlässigen Bereiche 221, 222 scharfkantig auf die fotosensitive Schicht 12 abgebildet.

Auch der obere lichtundurchlässige Bereich 231 wird auf die fotosensitive Schicht 12 abgebildet. Die Dicke des transparenten Substrats 21 beträgt einige hundert Mikrometer (µm), beispielsweise 500 µm. Der obere lichtundurchlässige Bereich 231 ist damit um ein Vielfaches weiter von der fotosensitiven Schicht 12 beabstandet als die unteren lichtundurchlässigen Bereiche 221, 222. An Kanten des oberen lichtundurchlässigen Bereichs 231 auftretende Beugungserscheinungen führen zu gebeugten Lichtstrahlen 2, die in einen Bereich unterhalb des lichtundurchlässigen Bereich 231 eindringen, der bei geometrischer Projektion der Lichtstrahlen 1 durch den lichtundurchlässigen Bereich 231verschattet wäre. Derartige Beugungserscheinungen treten auch an den unteren lichtundurchlässigen Bereichen 221, 222 auf, sind jedoch aufgrund des sehr viel geringeren Abstands dieser Bereiche zur fotosensitiven Schicht 12 vernachlässigbar.

In dem dargestellten Beispiel führen die gebeugten Lichtstrahlen 2 zu einer Belichtung der fotosensitiven Schicht 12 in einem Abschnitt 120 der fotosensitiven Schicht 12, der zwischen der linken Kante des oberen lichtundurchlässigen Bereich 231 und der rechten Kante des unteren lichtundurchlässigen Bereichs 221 liegt. In diesem Abschnitt 120 nimmt vorliegend die Lichtintensität von links nach rechts hin ab. Der lateral variierende Verlauf der Lichtintensität wird dabei von der Wahl der Geometrie der Anordnung der lichtundurchlässigen Bereiche 221, 222 und 231 und der verwendeten Wellenlänge bzw. Wellenlängenbereiche des Lichts 1 bestimmt.

Durch die Kombination von lichtundurchlässigen Bereichen 221, 231 auf der Unterseite 22 und der Oberseite 23 der Fotomaske 20 kann somit in einem Belichtungsgang eine Belichtung des Abschnitts 120 mit lateral abnehmender Belichtungsintensität erfolgen. In Abschnitten der Fotomaske 20, in denen ein lichtundurchlässiger Bereich 222 nur an der Unterseite 22 angeordnet ist, zeigt die Belichtungsintensität dagegen eine lateral annähernd sprunghaft wechselnde Belichtungsintensität.

Es wird angemerkt, dass die vorstehende Erläuterung auf der Basis der Strahlenoptik eine vereinfachte Sichtweise wiedergibt. Bei einer detaillierteren Beschreibung ist das einfallende Licht durch elektromagnetische Vektorfelder im dreidimensionalen Raum beschrieben. In diesem Zusammenhang lassen sich anschaulich Wellenfronten visualisieren. Beispielsweise werden die Felder an den Kanten der oberen lichtundurchlässigen Bereiche 231 und auch der unteren lichtundurchlässigen Bereiche 221, 222 maßgeschneidert in komplex gekrümmte Wellenfronten eines 3-dimensionalen Wellenfeldes überführt. Nur der Anschaulichkeit halber wird in der vorliegenden Anmeldung das Bild geometrischer Lichtstrahlen verwendet.

Im dargestellten Beispiel ist eine fotosensitive Schicht 12 verwendet, die durch Belichtung ätzresistent wird. Im Teilbild b) der Figur 1 ist die Mikrostruktur 10 nach einem Ätzschritt dargestellt, in dem nicht belichtete Teile der fotosensitiven Schicht 12 entfernt werden. Das belichtungsabhängige Entfernen der fotosensitiven Schicht 12 wird auch Entwickeln genannt. Wiedergegeben ist der gleiche Ausschnitt der Mikrostruktur 10 wie im Teilbild a). Die von der fotosensitiven Schicht 12 verbliebene Struktur weist im linken Bereich der Abbildung eine sprunghaft ansteigende Flanke 122 auf. Durch den Entwicklungsprozess ist die sprunghaft ansteigende Flanke 122 leicht unterschnitten.

Durch den kontinuierlichen Belichtungsverlauf im Abschnitt 120 nimmt auch die Resistenz gegen das Ätzmittel kontinuierlich entlang des Abschnitts 120 zu. Nach dem Ätzprozess spiegelt sich der kontinuierliche Verlauf der Ätzresistenz in einer flach ansteigenden Flanke 121 wider.

Es wird somit in nur einem fotolithographischen Schritt die fotosensitive Schicht 12 so belichtet, dass zwei unterschiedliche Flankentypen resultieren: die sprunghaft ansteigende, steile Flanke 122 und die kontinuierlich flach ansteigende Flanke 121. Die so strukturierte fotosensitive Schicht 12 stellt die Grundlage verschiedenster nachfolgend herstellbarer mikromechanischer Funktionselemente dar.

In Teilbild c) ist die Mikrostruktur 10 nach dem Aufdampfen einer funktionellen Schicht 13, beispielsweise einer Metallschicht, dargestellt. Die flach ansteigende Flanke 121 der verbliebenen fotosensitiven Schicht 12 wird überwachsen, so dass sich eine durchgehende Kante 131 der funktionellen Schicht 13 ausbildet. Die sprunghaft ansteigende Flanke 122 der verbliebenen fotosensitiven Schicht 12 führt dagegen zur Ausbildung einer unterbrochenen Kante 132 in der funktionellen Schicht 13.

In Teilbild d) ist die Mikrostruktur 10 nach einem weiteren Ätzvorgang dargestellt, in dem die verbleibende fotosensitive Schicht 12 entfernt wurde. Es ist so eine frei stehende Struktur der funktionellen Schicht 13 gebildet, die an der rechten Seite durch die durchgehende Kante 131 mit dem Substrat 11 verbunden ist und die bis zur linken unterbrochenen Kante 132 frei und beabstandet zur Substratoberfläche 11 stehend verläuft.

Eine derartige Struktur kann in unterschiedlicher Ausdehnung in einer Richtung senkrecht zur dargestellten Schnittebene hergestellt werden. Die in Richtung der Schnittebene verlaufenden Kanten können ebenfalls als unterbrochene Kanten vergleichbar zur unterbrochenen Kante 132 ausgebildet sein. Je nach Ausdehnung in einer Richtung senkrecht zur Schnittebene kann eine solche Struktur als Biegebalken oder als Mikrospiegel eingesetzt werden. Durch das dargestellte Verfahren kann eine solche freistehende und nur einseitig mit dem Substrat 11 verbundene Struktur mithilfe nur eines Belichtungsschrittes (vergleiche Teilbild a) hergestellt werden. Senkrecht zur dargestellten Schnittebene kann eine Mehrzahl derartiger freistehender Strukturen ausgebildet werden.

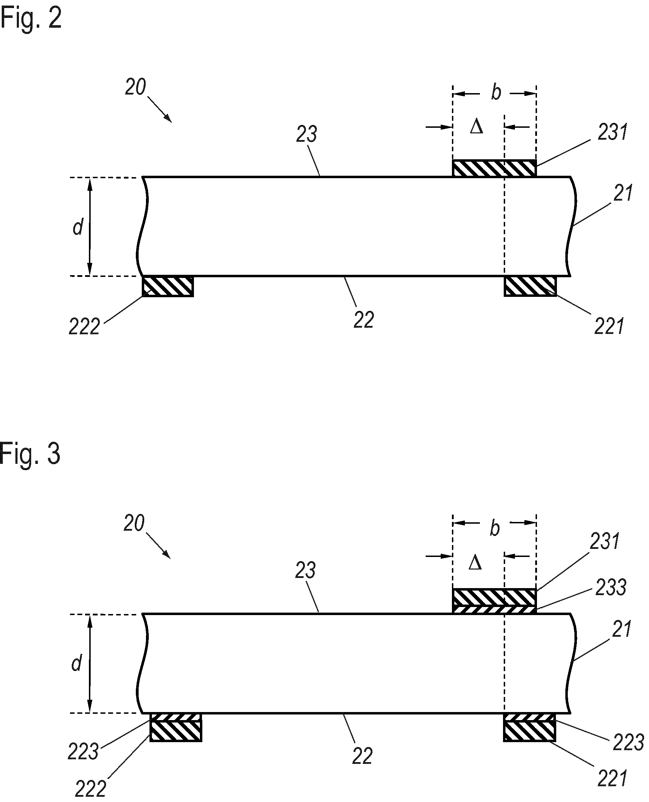

Figur 2 zeigt die im Ausführungsbeispiel der Figur 1 eingesetzte Fotomaske detaillierter. Gleiche Bezugszeichen kennzeichnen in dieser wie den folgenden Figuren gleiche oder gleichwirkende Elemente wie bei Figur 1. Bezüglich der einzelnen Elemente der Fotomaske 20 wird auf die Beschreibung zu Figur 1 verwiesen.

In Figur 2 sind insbesondere die Größe des oberen lichtundurchlässigen Bereichs 231 und die Position in seiner Kante relativ zur Kante des unteren lichtundurchlässigen Bereichs 221 angegeben. Es wird darauf hingewiesen, dass alle Figuren dieser Anmeldung schematische Zeichnungen darstellen, die insbesondere nicht maßstabsgetreu sind. So liegt eine Dicke d des transparenten Substrats 21 im Bereich von einigen hundert Mikrometern (µm), z.B. etwa 500 µm. Die Dicke der lichtundurchlässigen Bereiche 221, 222 und 231 liegt dagegen im Bereich von einigen 10 bis 100 nm.

Wie im Zusammenhang mit Figur 1 beschrieben ist, erfolgt die Ausbildung einer kontinuierlich flach ansteigenden Flanke 121 in der fotosensitiven Schicht 12 durch das Zusammenspiel des oberen lichtundurchlässigen Bereichs und dem unteren lichtundurchlässigen Bereich 221. Dabei ragt eine Kante des oberen lichtundurchlässigen Bereichs 231 um einen Überstand Δ über eine damit korrespondierende Kante des unteren lichtundurchlässigen Bereichs 221 hinaus. Bei Verwendung von Licht einer Wellenlänge von beispielsweise 350 nm liegt der Überstand Δ in einem Bereich von einigen Mikrometern, bei einer Breite b des oberen lichtundurchlässigen Bereichs 231 von einigen 10 µm, z.B. von 30 µm.

Figur 3 zeigt eine Weiterbildung des Ausführungsbeispiels von Figur 2, die sich in der Anordnung von reflexionsvermindernden Schichten 223 bzw. 233 zwischen dem transparenten Substrat 21 und den lichtundurchlässigen Bereichen 221 bzw. 231 befindet. Die reflexionsverringernden Schichten 223, 233 verhindern Reflektionen von Lichtstrahlen, insbesondere von an den Kanten des lichtundurchlässigen Bereichs 221 gebeugten Lichtstrahlen im Inneren des transparenten Substrats 21.

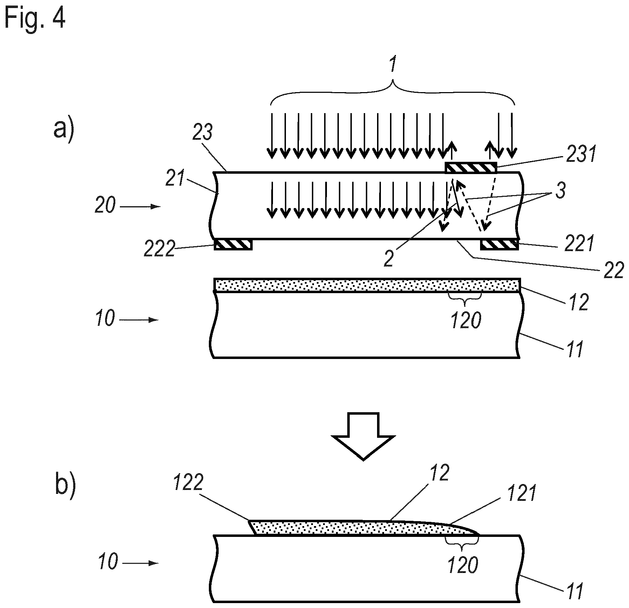

Figur 4 zeigt in zwei Teilbildern a) und b) analog zu den Teilbildern a) und b) der Figur 1 den Belichtungsvorgang einer fotosensitiven Schicht 12 einer Mikrostruktur 10 durch eine Fotomaske 20 (Teilbild a) sowie die Mikrostruktur 10 mit der nach einem Ätzvorgang verbleibende strukturierten fotosensitive Schicht 12.

Wie in Teilbild a) angedeutet ist, tritt Beugung an beiden Kanten des oberen lichtundurchlässigen Bereichs 231 an der Oberseite 23 der Fotomaske 20 auf. Die an der linken Kante gebeugten Lichtstrahlen 2 sind dabei gewünscht, um die fotosensitive Schicht 12 im Abschnitt 120 mit lateral abnehmender Beleuchtungsintensität zu belichten.

Beugung an der in der Figur rechten Kante der lichtundurchlässigen Struktur 231 führt zu gebeugten und ggf. reflektierten Lichtstrahlen 3, die in der Figur gestrichelt dargestellt sind. Diese Lichtstrahlen können unter Umständen direkt, in jedem Fall aber nach inneren Reflektionen in dem transparenten Substrat 21 neben dem unteren lichtundurchlässigen Bereich 221 austreten und sich mit den gebeugten Lichtstrahlen 2 überlagern. Diese Überlagerung kann zu einer ungewünschten Veränderung der abnehmenden Beleuchtungsintensität unterhalb des lichtundurchlässigen Bereichs 231 führen und die Form der flach ansteigenden Flanke 221 der fotosensitiven Schicht 12 unerwünscht beeinflussen.

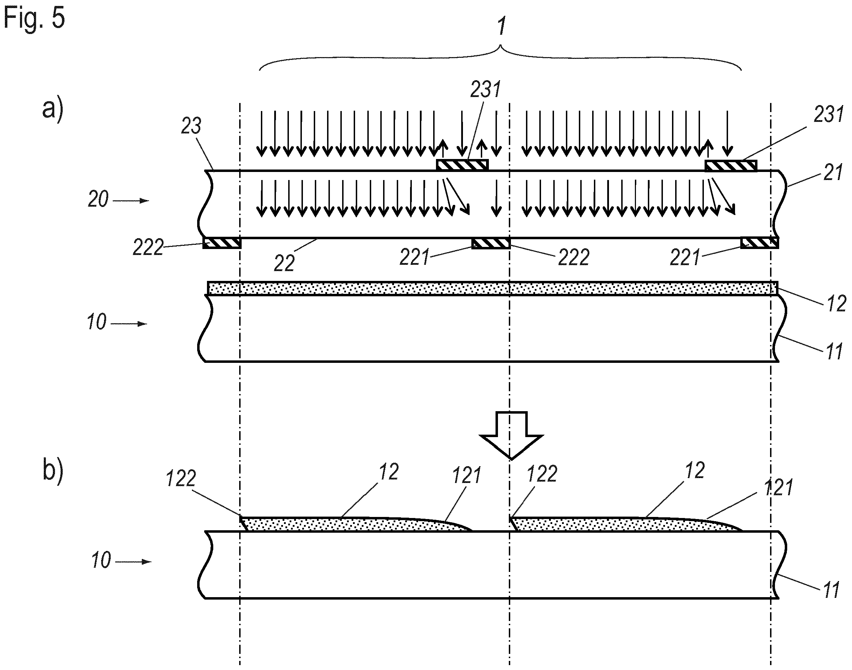

Um dieses zu verhindern, kann entweder die Breite b (vergleiche Figur 2) deutlich größer als der Überstand Δ gewählt werden. Auf diese Weise ist eine Vielzahl von internen Reflektionen notwendig, durch die die Intensität der gebeugten und reflektierten Lichtstrahlen 3 absinkt, bevor sie das transparente Substrat 21 verlassen können. Wie an dem Ausführungsbeispiel der Figur 5 ersichtlich ist, kann es zur Erzielung einer hohen Packungsdichte der Mikrostruktur 10 Beschränkungen für die Breite b des lichtundurchlässigen Bereichs 231 geben. Daher kann alternativ oder zusätzlich der störende Einfluss der gebeugten und intern reflektierten Lichtstrahlen 3 durch die in dem Ausführungsbeispiel der Figur 3 angegebenen reflexionsverringernden Schichten 223 und 233 verringert werden.

Figur 5 zeigt in Teilbildern a) und b) analog zu Figur 1 die Ausbildung von mehreren nebeneinander liegenden Strukturen mit verschiedenen Flankentypen. Beispielhaft sind hier zwei der gemäß Figur 1 ausgebildeten Strukturen nebeneinander dargestellt. Es versteht sich, dass die Anordnung jedoch so fortgesetzt werden kann, dass mehr als die dargestellten zwei Strukturen nebeneinander entstehen. Im Zusammenhang mit Figur 1 wurde bereits beschrieben, dass senkrecht zur Schnittrichtung der Darstellung eine Vielzahl einzelner Strukturen in einer Reihe liegend gebildet werden können. Werden, wie in Figur 5 gezeigt, mehrere derartiger Reihen nebeneinander ausgebildet, kann eine matrixförmige Anordnung (Array) beispielsweise von Biegebalken oder von Mikrospiegeln ausgebildet werden.

In dem in Figur 5 dargestellten Fall wird eine erste Struktur (links in der Figur) mit Hilfe von zwei unteren lichtundurchlässigen Bereichen 221 und 222 an der Unterseite 22 der Fotomaske 20 und einer oberen lichtundurchlässigen Struktur 231 auf der Oberseite 23 der Fotomaske 20 analog zu dem in Figur 1 beschriebenen Fall gebildet. An der rechten Seite der Figur 5 widerholt sich die überlappende Anordnung der lichtundurchlässigen Bereiche 221 und 231, so dass an dieser Stelle eine ansteigende Flanke 121 einer zweiten Struktur gebildet wird.

An der linken Seite der zweiten Struktur wird eine sprunghaft ansteigende Flanke 122 durch die Abschattung aufgrund der rechten Kante der angrenzenden unteren lichtundurchlässigen Struktur 221 gebildet, die somit die Funktion der unteren lichtundurchlässigen Struktur 222 übernimmt. In der Figur ist das durch Bezeichnung der rechten Kante mit den Bezugszeichen 222 in Klammern gesetzt symbolisiert. Die einander zugeordneten lichtundurchlässigen Bereiche 221 und 231 bewirken somit an ihrer linken Seite, an der die obere lichtundurchlässige Struktur 231 die untere lichtundurchlässige Struktur 221 überragt, die Ausbildung eines flach ansteigenden Flankentyps, wohingegen sie an ihrer rechten Seite, bei der die untere lichtundurchlässige Struktur 221 die obere lichtundurchlässige Struktur 231 überragt, der Ausbildung einer nahezu sprunghaft ansteigenden Flanke dient.

### Bezugszeichenliste

- 1: paralleles Lichtstrahlenbündel
- 2: gebeugte Lichtstrahlen
- 3: gebeugte und reflektierte Lichtstrahlen

- 10: Mikrostruktur
- 11: Trägersubstrat

- 12: fotosensitive Schicht
- 120: Abschnitt mit lateral variierender Beleuchtungsintensität
- 121: flach ansteigende Flanke
- 122: sprunghaft ansteigende Flanke

- 13: funktionale Schicht
- 131: durchgehende Kante
- 132: unterbrochene Kante

- 20: Fotomaske
- 21: transparentes Substrat

- 22: Unterseite
- 221, 222: untere lichtundurchlässige Bereiche
- 223: reflexionsvermindernde Schicht

- 23: Oberseite
- 231: obere lichtundurchlässige Bereiche
- 233: reflexionsvermindernde Schicht

## Patentansprüche

1. Verfahren zum Herstellen einer Mikrostruktur (10), aufweisend die folgenden Schritte:
- Bereitstellen einer fotosensitiven Schicht (12) auf einem Trägersubstrat (11);
- Anordnen einer Fotomaske (20) mit einem transparenten Substrat (21) auf oder über dem Trägersubstrat (11) der Mikrostruktur (10), wobei die Fotomaske (20) beidseitig mit einem Belichtungsmuster versehen ist, indem an einer dem Trägersubstrat (11) zuweisenden Unterseite (22) des Substrats (21) mindestens ein unterer lichtundurchlässiger Bereich (221, 222) und an einer gegenüberliegenden Oberseite (23) des Substrats (21) mindestens ein oberer lichtundurchlässiger Bereich (231) angeordnet ist;
- Belichten der fotosensitiven Schicht (12) durch die Fotomaske (20), wobei mindestens ein Abschnitt (120) der fotosensitiven Schicht (12) durch Lichtstrahlen (2) belichtet wird, die an einer Kante des oberen lichtundurchlässigen Bereichs (231) gebeugt sind;
- Entwickeln der fotosensitiven Schicht (12), wodurch sich aus dem mindestens einen Abschnitt (120) der fotosensitiven Schicht (12) ein in seiner Dicke lateral variierender Bereich ausbildet;
- Aufwachsen einer funktionalen Schicht (13) auf das Trägersubstrat (11) und die nach dem Entwickeln verbliebene fotosensitive Schicht (12), wobei der Bereich variierender Dicke der verbliebenen fotosensitiven Schicht (12) überwachsen wird;
- Entfernen der verbliebenen fotosensitiven Schicht (12).

2. Verfahren nach Anspruch 1, bei dem der obere lichtundurchlässige Bereich (231) einem der unteren lichtundurchlässigen Bereiche (221) gegenüberliegt und diesen zumindest mit einer Kante seitlich überragt.

3. Verfahren nach Anspruch 2, bei dem der obere lichtundurchlässige Bereich (231) den unteren lichtundurchlässigen Bereich (221) um einen Abstand, der 2 bis 20 Wellenlängen des Lichts der Lichtstrahlen (2) entspricht, seitlich an zumindest einer Kante überragt.

4. Verfahren nach einem der Ansprüche 1 bis 3, bei dem der in seiner Dicke lateral variierende Bereich als eine flach ansteigende Flanke (121) ausgebildet ist.

5. Verfahren nach einem der Ansprüche 1 bis 4, bei dem eine Kante eines der unteren lichtundurchlässigen Bereiche (222) durch nicht gebeugte parallele Lichtstrahlen (1) unmittelbar auf die fotosensitive Schicht (12) abgebildet wird, wodurch beim Entwickeln der fotosensitiven Schicht (12) eine nahezu sprunghaft ansteigende Flanke (122) ausbildet wird.

6. Verfahren nach Anspruch 4 oder 5, bei dem die funktionale Schicht (13) an der Stelle der flach ansteigenden Flanke (121) eine durchgehende Kante (131) aufweist, wobei sie ausgehend von der durchgehende Kante (131) zu einer Seite hin mit dem Trägersubstrat (11) verbunden ist und zu der anderen Seite hin zunehmend beabstandet von dem Trägersubstrat (11) verläuft.

7. Verfahren nach Anspruch 5 und 6, bei dem die funktionale Schicht (13) an der Stelle der steil ansteigenden Flanke (122) eine unterbrochene Kante (132) aufweist, wobei ein Abschnitt zwischen der durchgehenden Kante (131) und der unterbrochenen Kante (132) freistehend ist.

8. Verfahren nach Anspruch 7, bei dem die funktionale Schicht (13) zwischen der durchgehenden Kante (131) und der unterbrochenen Kante (132) einen Biegebalken oder einen Mikrospiegel bildet.

9. Verfahren nach einem der Ansprüche 1 bis 8, wobei an der Unterseite (22) und/oder der Oberseite (23) des transparenten Substrats (21) bereichsweise phasenverschiebend wirkende Schichten und/oder reflexionsvermindernden Schichten (223, 233) angeordnet sind.

## Claims

1. Method for producing a microstructure (10), comprising the steps of:
- providing a photosensitive layer (12) on a carrier substrate (11);
- arranging a photomask (20) having a transparent substrate (21) on or above the carrier substrate (11) of the microstructure (10), wherein the photomask (20) is provided on both sides with an exposure pattern, in that at least one lower light-impermeable region (221, 222) is arranged on a bottom side (22) of the substrate (21) facing the carrier substrate (11) and at least one upper light-impermeable region (231) is arranged on an opposite top side (23) of the substrate (21);
- exposing the photosensitive layer (12) through the photomask (20), wherein at least one section (120) of the photosensitive layer (12) is exposed by light beams (2) diffracted at an edge of the upper light-impermeable region (231);
- developing the photosensitive layer (12), whereby a region having laterally varying thickness is formed from the at least one section (120) of the photosensitive layer (12);
- growing a functional layer (13) onto the carrier substrate (11) and the photosensitive layer (12) remaining after development, wherein the region of varying thickness of the remaining photosensitive layer (12) is overgrown;
- removing the remaining photosensitive layer (12).

2. Method according to claim 1, in which the upper light-impermeable region (231) is disposed opposite of one of the lower light-impermeable regions (221) and laterally projects over said region (221) at least with one edge.

3. Method according to claim 2, in which the upper light-impermeable region (231) laterally projects at at least one edge over the lower light-impermeable region (221) by a distance corresponding to 2 to 20 wavelengths of the light of the light beams (2).

4. Method according to one of claims 1 to 3, in which the region varying laterally in thickness is formed as a flat rising flank (121).

5. Method according to one of claims 1 to 4, in which an edge of one of the lower light-impermeable regions (222) is imaged directly onto the photosensitive layer (12) by non-diffracted parallel light beams (1), thereby forming an almost abruptly rising flank (122) when developing the photosensitive layer (12).

6. Method according to claim 4 or 5, in which the functional layer (13) has a continuous edge (131) at the location of the flat rising flank (121), wherein starting from the continuous edge (131) it is connected to the carrier substrate (11) towards one side and extends towards the other side increasingly spaced from the carrier substrate (11).

7. Method according to claim 5 and 6, in which the functional layer (13) comprises a discontinuous edge (132) at the location of the steeply rising flank (122), wherein a section between the continuous edge (131) and the discontinuous edge (132) is free-standing.

8. Method according to claim 7, in which the functional layer (13) between the continuous edge (131) and the interrupted edge (132) forms a bending beam or a micromirror.

9. Method according to one of claims 1 to 8, wherein phase-shifting layers and/or reflection-reducing layers (223, 233) are arranged in sections on the bottom side (22) and/or the top side (23) of the transparent substrate (21).

## Revendications

1. Procédé de fabrication d'une microstructure (10), comprenant les étapes consistant à :
- préparer une couche photosensible (12) sur un substrat de support (11) ;
- disposer un masque photographique (20) avec un substrat transparent (21) sur ou au-dessus du substrat de support (11) de la microstructure (10), le masque photographique (20) étant pourvu des deux côtés d'un motif d'exposition, en disposant au moins une zone opaque inférieure (221, 222) sur une face inférieure (22) du substrat (21) tournée vers le substrat de support (11) et au moins une zone opaque supérieure (231) sur une face supérieure opposée (23) du substrat (21) ;
- exposer la couche photosensible (12) à travers le masque photographique (20), au moins une partie (120) de la couche photosensible (12) étant exposée à des rayons lumineux (2) qui sont diffractés au niveau d'un bord de la zone opaque supérieure (231) ;
- développer la couche photosensible (12), de sorte qu'il se forme une zone dont l'épaisseur varie latéralement à partir de ladite au moins une partie (120) de la couche photosensible (12) ;
- faire croître une couche fonctionnelle (13) sur le substrat de support (11) et sur la couche photosensible (12) restante après le développement, la zone d'épaisseur variable de la couche photosensible restante (12) étant recouverte par la croissance ;
- éliminer la couche photosensible restante (12).

2. Procédé selon la revendication 1, dans lequel la zone opaque supérieure (231) fait face à l'une des zones opaques inférieures (221) et la dépasse latéralement au moins par un bord.

3. Procédé selon la revendication 2, dans lequel la zone opaque supérieure (231) dépasse latéralement, au niveau d'au moins un bord, la zone opaque inférieure (221) d'une distance qui correspond à 2 à 20 longueurs d'onde de la lumière des rayons lumineux (2).

4. Procédé selon l'une des revendications 1 à 3, dans lequel la zone dont l'épaisseur varie latéralement est réalisée sous la forme d'un flanc à faible pente ascendante (121).

5. Procédé selon l'une des revendications 1 à 4, dans lequel un bord de l'une des zones opaques inférieures (222) est imagé directement sur la couche photosensible (12) par des rayons lumineux parallèles non diffractés (1), ce qui permet de former un flanc à pente ascendante quasi brusque (122) lors du développement de la couche photosensible (12).

6. Procédé selon la revendication 4 ou 5, dans lequel la couche fonctionnelle (13) présente un bord continu (131) au niveau du flanc à faible pente ascendante (121) et, en partant du bord continu (131) vers un côté, est reliée au substrat de support (11) et, vers l'autre côté, s'étend à une distance croissante du substrat de support (11).

7. Procédé selon les revendications 5 et 6, dans lequel la couche fonctionnelle (13) présente un bord interrompu (132) au niveau du flanc à forte pente ascendante (122), une partie située entre le bord continu (131) et le bord interrompu (132) étant libre.

8. Procédé selon la revendication 7, dans lequel la couche fonctionnelle (13) entre le bord continu (131) et le bord interrompu (132) forme une poutre de flexion ou un micromiroir.

9. Procédé selon l'une des revendications 1 à 8, dans lequel des couches ayant un effet déphaseur et/ou des couches réduisant la réflexion (223, 233) sont disposées dans certaines zones sur la face inférieure (22) et/ou la face supérieure (23) du substrat transparent (21).
